# EUROPEAN PATENT APPLICATION

(11) **EP 4 697 890 A2**
(43) Date of publication of application: **18.02.2026**
(21) Application number: 25221145.3
(22) Date of filing: 06.12.2021
(51) Int. Cl.: H10D 62/17

(54) **FIELD EFFECT TRANSISTOR AND METHOD OF MANUFACTURING THEREOF**

(62) Divisional of application: 21830650.4
(71) Applicant: Huawei Technologies Co., Ltd., Shenzhen, Guangdong 518129 (CN)
(72) Inventor: CURATOLA, Gilberto, 80992 Munich (DE)
(74) Representative: Isarpatent

(57) **Abstract**

A member includes a buffer layer made of GaN. The member is characterized in that the member includes a source layer arranged on top of the buffer layer, and the source layer made of n-doped GaN. The member includes a first barrier layer made of Al-GaN arranged over the buffer layer and a first gate layer made of p-doped GaN arranged over the first barrier layer, where the first barrier layer and the first gate layer are arranged adjacent the source layer on one side. The member includes a second barrier layer made of Al-GaN arranged over the buffer layer and a second gate layer made of p-doped GaN arranged over the second barrier layer, where the second barrier layer and the second gate layer are arranged adjacent the source layer on another side. The member enables an independent optimization of the two-dimensional electron gas characteristics and the threshold voltage.

## Description

### TECHNICAL FIELD

The present disclosure relates generally to the field of semiconductor devices and more specifically, to a member (e.g., a semiconductor structure), a method of manufacturing the member, and a transistor (e.g., a field effect transistor) comprising the member.

### BACKGROUND

Generally, a semiconductor device is based on electronic properties of a semiconductor material, such as silicon (Si), germanium (Ge), and the like, for its functioning. The semiconductor device is generally manufactured either as an individual device or as an integrated circuit (IC) device, using a conventional silicon-based semiconductor technology. However, the conventional silicon-based semiconductor technology has certain limits in terms of on-state resistance versus breakdown voltage. There is a super junction concept that has been extensively proven and applied to the conventional silicon-based semiconductor technology to surpass such limits. In the super junction concept, p-type doped vertical stripes are added in a drift region of the semiconductor device, which results in the formation of new PN-junctions. The super junction concept allows achieving a flat electric field distribution in the semiconductor device due to lateral depletion of an adjacent PN junction. Because of the flat electric field distribution, the super junction concept manifests a much higher doping profile and reduces a minimum achievable on-state resistance.

Currently, intensive efforts are taken to develop a possible replacement of the conventional silicon technology (or Si-based field-effect transistors (FETs)), for example, by development of wide bandgap (WBG) semiconductor materials-based technology. The wide bandgap semiconductor materials provide a partially improved performance both at a device level as well as at a system level as compared to the conventional silicon-based semiconductor technology. For example, conventional enhancement-mode gallium nitride (GaN) based power FETs (or MOSFETs) are already used by semiconductor manufacturers in various commercial products. The conventional enhancement-mode GaN based power FETs utilize a p-doped GaN normally-off concept. The p-doped GaN power transistor includes a thin aluminium gallium nitride (AlGaN) barrier layer, which is grown onto a GaN buffer layer in order to create a two-dimensional electron gas (2DEG) at the AlGaN/GaN interface. In the 2DEG, a gate module (may also be referred to as a gate metal) is composed of a p-type doped layer (e.g., magnesium is usually used as a p-type dopant), which is defined below the gate module only in the gate region. The p-doped GaN layer depletes the two-dimensional electron gas (2DEG) in the gate region and allows fabrication of the conventional enhancement-mode (normally-off) GaN power transistors. The conventional p-doped GaN power transistor, generally, includes a single AlGaN barrier layer, with a certain thickness and aluminium (Al) content, which is used to define electrical characteristics of the two-dimensional electron gas (2DEG). However, the conventional p-doped GaN power transistor has certain limitations, such as the threshold voltage and the two-dimensional electron gas (2DEG) characteristics cannot be controlled independently. Moreover, the conventional p-doped GaN power transistor is highly sensitive to surface effects (i.e., dynamic effects) and the gate module details (e.g., Schottky vs. Ohmic). Additionally, the conventional p-doped GaN power transistor manifests reduced current capabilities and low threshold voltage (e.g., approximately 1-1.5V). The reason being the conventional p-doped GaN power transistor is highly sensitive to parasitic and voltage and current overshoots. Therefore, there exists a technical problem of how to independently control the threshold voltage and the two-dimensional electron gas (2DEG) characteristics of the conventional p-doped GaN power transistor as well as to make the conventional p-doped GaN power transistor sufficiently immune to the surface effects.

Therefore, in light of the foregoing discussion, there exists a need to overcome the aforementioned drawbacks associated with the conventional p-doped GaN power transistor.

### SUMMARY

The present disclosure provides a member (e.g., a semiconductor structure), a method of manufacturing the member, and a transistor (e.g., a field effect transistor) comprising the member. The present disclosure provides a solution to the existing problem of how to independently control the threshold voltage and the two-dimensional electron gas (2DEG) characteristics of the conventional p-doped GaN power transistor as well as to make the conventional p-doped GaN power transistor sufficiently immune to the surface effects. An objective of the present disclosure is to provide a solution that overcomes at least partially the problems encountered in the prior art and provides an improved member (e.g., a semiconductor structure), a method of manufacturing the member, and a transistor (e.g., a field effect transistor) comprising the member with a tunable threshold voltage.

One or more objectives of the present disclosure is achieved by the solutions provided in the enclosed independent claims. Advantageous implementations of the present disclosure are further defined in the dependent claims.

In one aspect, the present disclosure provides a member comprising a buffer layer comprising gallium nitride (GaN). The member is characterized in that the member further comprises a source layer arranged on top of the buffer layer, and the source layer comprises n-doped GaN. The member further comprises a first barrier layer comprising Al-GaN arranged over the buffer layer and a first gate layer comprising p-doped GaN arranged over the first barrier layer, where the first barrier layer and the first gate layer is arranged adjacent the source layer on one side. The member further comprises a second barrier layer comprising Al-GaN arranged over the buffer layer and a second gate layer comprising p-doped GaN arranged over the second barrier layer, where the second barrier layer and the second gate layer is arranged adjacent the source layer on another side.

The member enables an independent optimization of a two-dimensional electron gas (2DEG) characteristics and threshold voltage (Vth) of a semiconductor device (e.g., a power transistor). Moreover, the member manifests a high immunity to dynamic effects (or surface effects). The member is less sensitive to the thickness and concentration of each of the first and second barrier layers. The member allows a high 2DEG density to boost on-state resistance. However, the on-state resistance and the threshold voltage can be controlled independently.

In an implementation form, one or more drain (D) contacts are arranged on at least one of the first and second barrier layers, one or more gate (G) contacts are arranged on at least one of the first and second gate layers, and a source (S) contact is arranged on the source layer.

Each of the one or more drain (D) contacts, the one or more gate (G) contacts, and the source (S) contact is arranged for electric field management.

In a further implementation form, the source layer is arranged in a hole in the first and second barrier layers and the first and second gate layers, where the source layer is sandwiched between the first and second barrier layers and the first and second gate layers.

The source layer is arranged in the hole in the first and second barrier layers and the first and second gate layers, in order to improve the electrical properties of the member, which further results in improved electrical properties of a semiconductor device comprising the member.

In a further implementation form, the hole is formed in an original barrier layer and an original gate layer, the first and second barrier layers and the first and second gate layers and, where the source layer is a regrown body of n-doped GaN in the hole.

By virtue of using the source layer as the regrown body of n-doped GaN in the hole, on-state resistance of a semiconductor device as well as its overall breakdown capabilities are improved.

In a further implementation form, the member comprises a first portion of the member, the first portion is arranged, in operation, to have current flow through it in a vertical direction, and a second portion of the member, the second portion is arranged, in operation, to have current flow through it in a lateral direction, and where the threshold voltage of the member is dependent on the first portion.

The member manifests the advantages of a conventional GaN lateral technology as well as the benefits of a vertical device architecture due to the presence of the first portion and the second portion.

In a further implementation form, the first portion of the member comprises the source layer and a portion of the first gate layer, and where the second portion of the member comprises the remainder of the first gate layer and, the first barrier layer.

By virtue of using such arrangement of the first portion as well as the second portion, the member combines the advantages of a lateral technology with that of a pure vertical technology. Additionally, the member manifests a reduced manufacturing complexity using such arrangement of the first portion as well as the second portion.

In a further implementation form, the first portion of the member further comprises a portion of the second gate layer, and where the second portion of the member further comprises the remainder of the second gate layer and the second barrier layer.

By virtue of using such arrangement of the first portion as well as the second portion, the member combines the advantages of a lateral technology with that of a pure vertical technology. Additionally, the member manifests a reduced manufacturing complexity using such arrangement of the first portion as well as the second portion.

In a further implementation form, the source layer has a first length in a first lateral direction and a length in a second lateral direction, each of the first and second gate layers has a first length in a first lateral direction and a length in a second lateral direction, where the lengths of either gate layer are measured from the source layer, and each of the first and second barrier layers has a first length in a first lateral direction and a length in a second lateral direction, where the lengths of either barrier layer are measured from the source layer, where the first lateral direction is orthogonal to the second lateral direction.

By virtue of having the dimensions of each of the source layer, the first and second gate layers and the first and second barrier layers, in the first lateral direction and the second lateral direction, a tunable threshold voltage can be obtained.

In a further implementation form, the member further comprises one or more further first barrier layers and one or more first intermediate buffer layers arranged between the first barrier layer and the buffer layer and one or more further second barrier layers and one or more second intermediate buffer layers arranged between the second barrier layer and the buffer layer, where the further barrier layers comprise AlGaN, and where the intermediate buffer layers comprise GaN.

By virtue of using the one or more further first barrier layers and the one or more first intermediate buffer layers arranged between the first barrier layer and the buffer layer and the one or more further second barrier layers and one or more second intermediate buffer layers arranged between the second barrier layer and the buffer layer, multiple channels in parallel are created, which further enhance the electrical properties of the member.

In another aspect, the present disclosure provides a method of manufacturing a member. The method comprises depositing a sacrificial layer on top of an epitaxial stack. The epitaxial stack comprises a buffer layer comprising GaN, a barrier layer comprising Al-GaN arranged over the buffer layer, and a gate layer comprising p-doped GaN arranged over the barrier layer, where the sacrificial layer indicates location for a hole. The method further comprises etching the hole through the gate layer and the barrier layer as indicated by the sacrificial layer and regrowing a source layer comprising n-doped GaN in the hole. The method further comprises removing the sacrificial layer and structuring the gate layer exposing a portion of the barrier layer and depositing a passivation layer over the exposed portion of the barrier layer, the gate layer and the source layer. The method further comprises arranging one or more drain contacts on the barrier layer, arranging one or more gate contacts on the gate layer and arranging a source contact on the source layer.

The method achieves all the advantages and technical effects of the member of the present disclosure.

In yet another aspect, the present disclosure provides a field effect transistor (FET) having a source contact, one or more gate contacts and, one or more drain contacts. The FET comprises a junction field effect transistor (JFET) and a first and a second heterostructure FETs. The JFET is arranged to provide the source contact of the FET and, the first and the second heterostructure FETs are arranged to provide the one or more gate contacts and the one or more drain contacts of the FET.

The FET achieves all the advantages and technical effects of the member of the present disclosure.

It is to be appreciated that all the aforementioned implementation forms can be combined. It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
FIG. 1 is a schematic illustration of a member, in accordance with an embodiment of the present disclosure;
FIGs. 2A, 2B, and 2C collectively illustrate a schematic process for manufacturing a member in two-dimensions (2D), in accordance with an embodiment of the present disclosure;
FIG. 3A is a schematic illustration of a member, in accordance with another embodiment of the present disclosure;
FIG. 3B is a schematic illustration of a member, in accordance with yet another embodiment of the present disclosure;
FIGs. 4A and 4B collectively illustrate a schematic process for manufacturing a member in three-dimensions (3D), in accordance with an embodiment of the present disclosure;
FIG. 5 is a flowchart of a method of manufacturing a member, in accordance with an embodiment of the present disclosure;
FIG. 6 is a schematic illustration of a field effect transistor (FET), in accordance with an embodiment of the present disclosure;
FIG. 7A is a graphical representation that illustrates simulated electrical transfer characteristics of a semiconductor device, as a function of voltage applied to a gate electrode and for different values of lateral extension of gallium nitride (GaN) regrown region, in accordance with an embodiment of the present disclosure; and
FIG. 7B is a graphical representation that illustrates simulated electrical transfer characteristics of a semiconductor device, as a function of voltage applied to a gate electrode and for different values of n-type doping concentration in the gallium nitride (GaN) regrown region, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

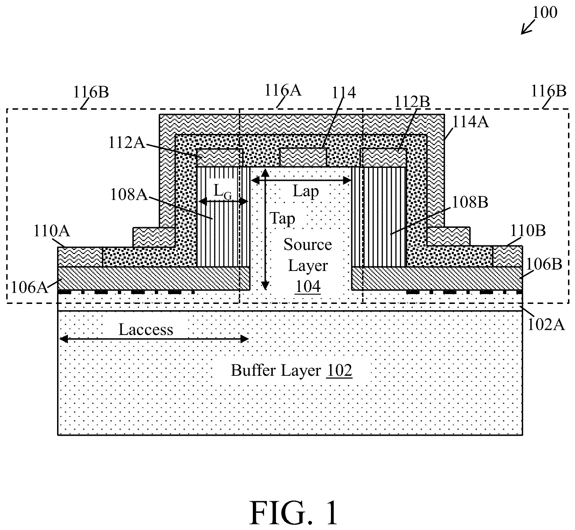

FIG. 1 is a schematic illustration of a member, in accordance with an embodiment of the present disclosure. With reference to FIG. 1, there is shown a schematic illustration of a member **100** that includes a buffer layer **102,** a source layer **104,** a first barrier layer **106A,** a second barrier layer **106B,** a first gate layer **108A,** and a second gate layer **108B.** The member **100** further includes one or more drain contacts, such as a first drain contact **110A** and a second drain contact **110B,** one or more gate contacts, such as a first gate contact **112A,** and a second gate contact **112B,** and a source contact **114.** There is further shown a first portion **116A** and a second portion **116B** of the member **100.** There is further shown a metal layer **114A.**

The member **100** is a semiconductor structure that includes one or more layers of semiconductor material. In an example, the semiconductor material of one layer may be the same (or different) as compared to the semiconductor material of another layer. The member **100** may also comprise layers or structures of materials other than the semiconductor materials. Further, the member **100** may constitute a semiconductor device or be comprised in the semiconductor device. The member **100** corresponds to an epitaxial stack. The member **100** may be represented either as a two-dimensional structure or a three-dimensional structure.

The buffer layer **102** is a layer of gallium nitride (GaN) semiconductor material, which is a wide-bandgap (WBG) semiconductor material. The bandgap of the buffer layer **102** is of a value of 3.4 electron volt (eV). The buffer layer **102** is generally composed of a top part **102A** that acts as an un-intentionally doped (UID) GaN channel and a bottom part that is generally carbon doped. The carbon doped bottom part provides a significant decrease in the lateral parasitic leakage current and also, an increase in overall breakdown voltage of a semiconductor device (both horizontally and vertically).

The source layer **104** is a layer of n-doped GaN, and arranged over the buffer layer **102.**

Each of the first barrier layer **106A,** and the second barrier layer **106B** is a layer of aluminium gallium nitride (AlGaN) semiconductor material. Each of the first barrier layer **106A,** and the second barrier layer **106B** is arranged over the buffer layer **102** in order to create a two-dimensional electron gas (2DEG) at the AlGaN/GaN interface. The 2DEG is represented by a dotted line on adjacent sides of the source layer **104** in the member **100,** as shown in FIG. 1. The 2DEG is a scientific model in solid-state physics, where the two-dimensional electron gas is free to move in two dimensions, but tightly confined in a third dimension. Moreover, such tight confinement leads to quantized energy levels for the motion of the two-dimensional electron gas in the third dimension, which can then be ignored for most problems. Thus, the two-dimensional electron gas appears to be a two-dimensional (2D) sheet embedded in a three-dimensional (3D) world. Each of the first barrier layer **106A,** and the second barrier layer **106B** may also be referred to as an access region.

Each of the first gate layer **108A,** and the second gate layer **108B** is a layer of p-doped GaN semiconductor material. The first gate layer **108A** and the second gate layer **108B** are arranged over the first barrier layer **106A,** and the second barrier layer **106B,** respectively. Usually, magnesium (Mg) is used as a p-type dopant to the gallium nitride (GaN) semiconductor material.

Each of the one or more drain contacts, such as the first drain contact **110A** and the second drain contact **110B,** the one or more gate contacts, such as the first gate contact **112A,** and the second gate contact **112B,** and the source contact **114** correspond to a metal drain contact, a metal gate contact, and a metal source contact terminal, respectively, of the member **100,** which is used for electrical connection purposes. Generally, the metal used for each of the first drain contact **110A,** the second drain contact **110B,** the first gate contact **112A,** and the second gate contact **112B,** and the source contact **114** may be one of or a combination of palladium (Pd), titanium (Ti), titanium nitride (TiN), gold (Au), nickel (Ni), aluminium (Al), and tungsten (W).

The member **100** comprises the buffer layer **102** comprising gallium nitride (GaN). The member **100** is characterized in that the member **100** further comprises the source layer **104** arranged on top of the buffer layer **102.** The source layer **104** comprises n-doped GaN. The member **100** further comprises the first barrier layer **106A** comprising Al-GaN arranged over the buffer layer **102** and the first gate layer **108A** comprising p-doped GaN arranged over the first barrier layer **106A,** where the first barrier layer **106A** and the first gate layer **108A** is arranged adjacent to the source layer **104** on one side. In the member **100,** the source layer **104** made of the n-doped GaN semiconductor material is arranged on top of the buffer layer **102.** Additionally, the first barrier layer **106A** made of the Al-GaN semiconductor material is arranged over the buffer layer **102.** In an implementation of the member **100,** the first barrier layer **106A** may be arranged directly on top of the buffer layer **102.** In another implementation of the member **100,** the first barrier layer **106A** may be arranged above the buffer layer **102** potentially with another material in between the first barrier layer **106A** and the buffer layer **102.** For example, the top part **102A** (i.e., UID GaN channel) of the buffer layer **102** may be arranged in between the first barrier layer **106A** and the buffer layer **102.** Moreover, the first gate layer **108A** made of p-doped GaN semiconductor material is arranged over the first barrier layer **106A.** Each of the first barrier layer **106A** and the first gate layer **108A** is arranged adjacent (e.g., on left side) of the source layer **104.**

The member **100** further comprises the second barrier layer **106B** comprising Al-GaN arranged over the buffer layer **102** and the second gate layer **108B** comprising p-doped GaN arranged over the second barrier layer **106B,** where the second barrier layer **106B** and the second gate layer **108B** is arranged adjacent to the source layer **104** on another side. Similar to the first barrier layer **106A,** the second barrier layer **106B** is made of the Al-GaN semiconductor material and is arranged either directly on top of the buffer layer **102** or above the buffer layer **102** potentially with the other material (e.g., the top part **102A,** UID GaN channel, of the buffer layer **102**) in between the second barrier layer **106B** and the buffer layer **102.** Similar to the first gate layer **108A,** the second gate layer **108B** is made of the p-doped GaN semiconductor material and is arranged over the second barrier layer **106B.** Each of the second barrier layer **106B** and the second gate layer **108B** is arranged adjacent (e.g., right side) to the source layer **104.** Alternatively stated, each of the second barrier layer **106B** and the second gate layer **108B** is arranged on opposite side to the side of the source layer **104** on which each of the first barrier layer **106A** and the first gate layer **108A** is arranged.

In accordance with an embodiment, the one or more drain, D, contacts are arranged on at least one of the first and second barrier layers **106A, 106B.** The one or more gate, G, contacts are arranged on at least one of the first and second gate layers **108A, 108B,** and the source, S, contact **114** is arranged on the source layer **104.** The one or more drain (may also be represented as D) contacts, such as the first drain contact **110A** and the second drain contact **110B** is arranged on the first barrier layer **106A** and the second barrier layer **106B,** respectively. Similarly, the one or more gate (may also be represented as G) contacts, such as the first gate contact **112A** and the second gate contact **112B** is arranged on the first gate layer **108A** and the second gate layer **108B,** respectively. In an implementation, each of the first drain contact **110A** and the first gate contact **112A** arranged on the first barrier layer **106A** and the first gate layer **108A,** respectively, lies on left side of the source layer **104.** Additionally, each of the second drain contact **110B** and the second gate contact **112B** arranged on the second barrier layer **106B** and the second gate layer **108B,** respectively, lies on right side of the source layer **104.** The source (may also be represented as S) contact **114** is arranged on the source layer **104.** Furthermore, each of the one or more drain contacts, the one or more gate contacts and the source contact **114** may be either ohmic or Schottky, depending on use. Moreover, the metal layer **114A** is used for electric field management. The metal layer **114A** is configured to operate at a certain potential (e.g., same as that of the source contact **114**) in the member **100.** The metal layer **114A** may also be referred to as a metal plate, which may be either ohmic or Schottky, depending on use.

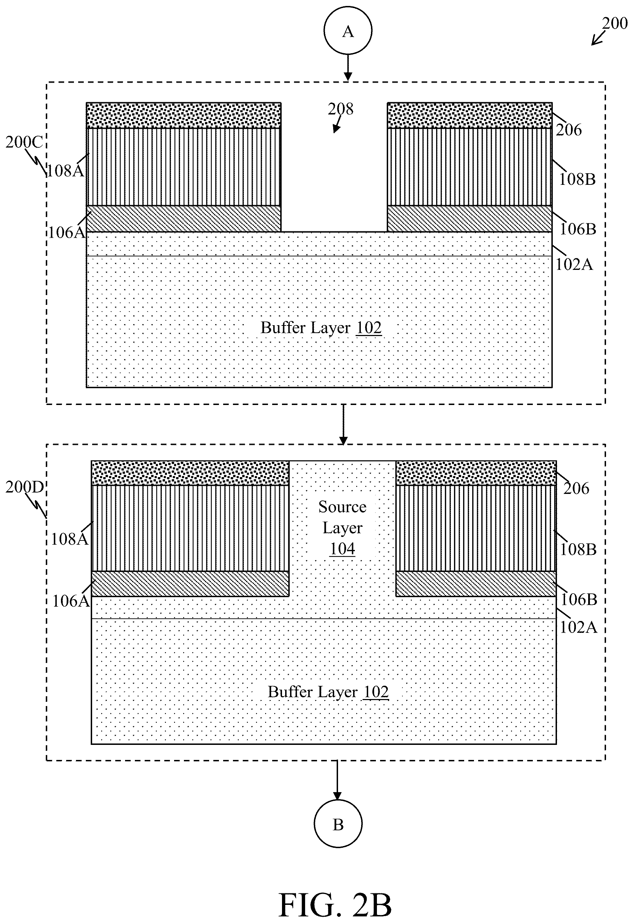

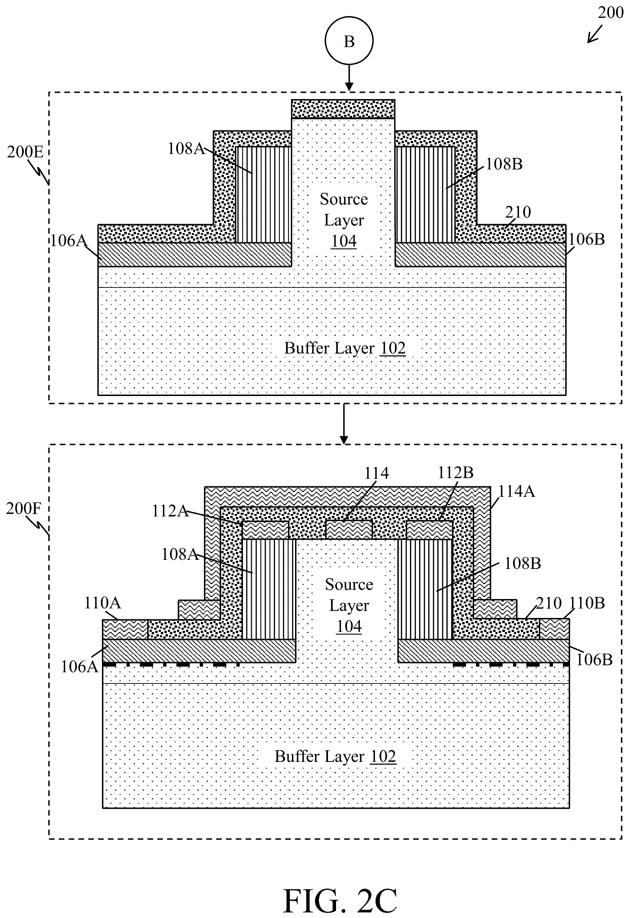

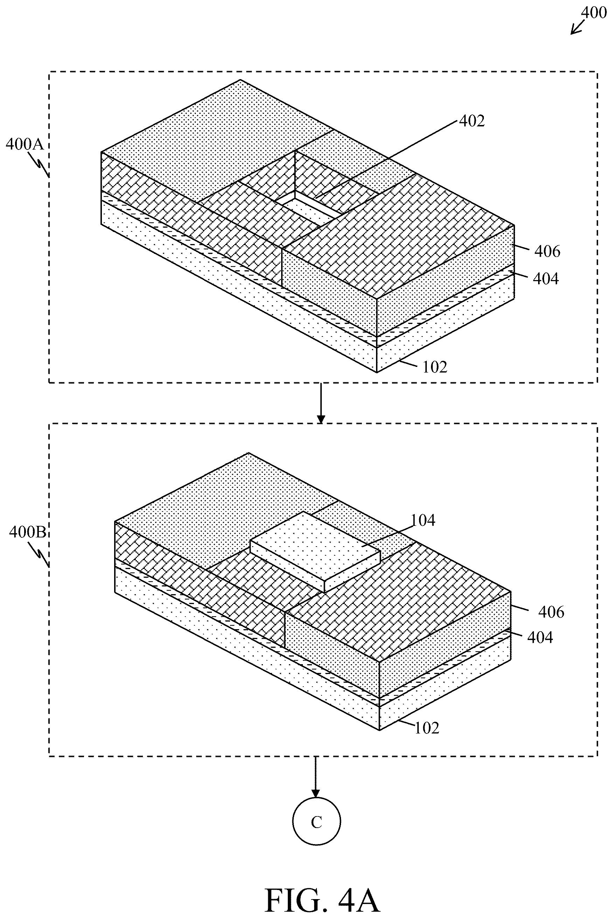

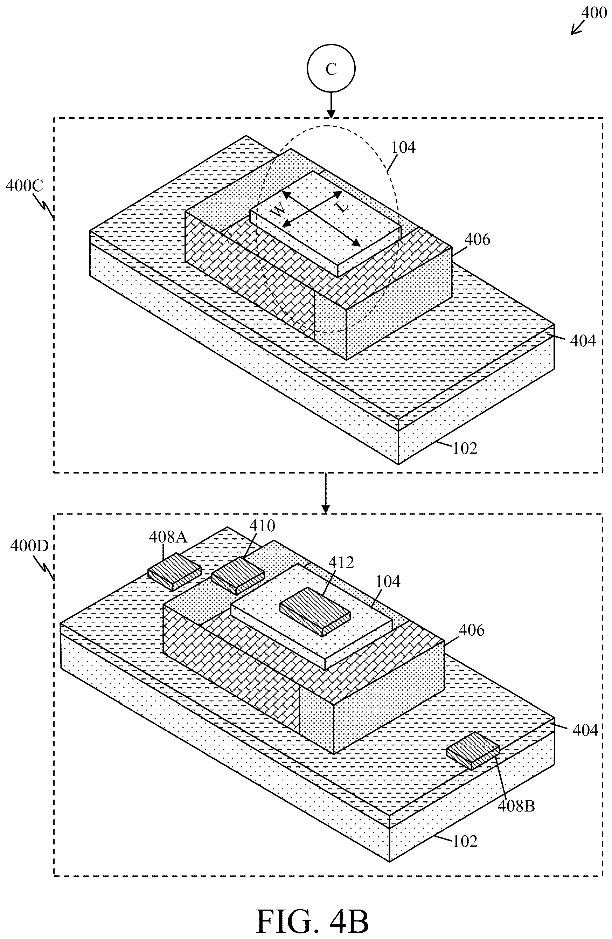

In accordance with an embodiment, the source layer **104** is arranged in a hole in the first and second barrier layers **106A, 106B** and the first and second gate layers **108A, 108B,** where the source layer **104** is sandwiched between the first and second barrier layers **106A, 106B** and the first and second gate layers **108A, 108B.** In an implementation, the source layer **104** is arranged as the hole in the first and second barrier layers **106A, 106B** and the first and second gate layers **108A,108B.** Alternatively stated, the source layer **104** is sandwiched between the first and second barrier layers **106A, 106B** and the first and second gate layers **108A, 108B.** The more details are provided in FIGs. 2B, 2C, 4A, and 4B.

In accordance with an embodiment, the member **100** comprises the first portion **116A** of the member **100.** The first portion **116A** is arranged, in operation, to have current flow through it in a vertical direction. The member **100** further comprises the second portion **116B** of the member **100.** The second portion **116B** is arranged, in operation, to have current flow through it in a lateral direction, and where the threshold voltage of the member **100** is dependent on the first portion **116A.** The first portion **116A** of the member **100** may extend from the hole in which, the source layer **104** is arranged, in a vertical direction, so that the current flows through it (i.e., the first portion **116A**) in the vertical direction. Additionally, the second portion **116B** of the member **100** may extend laterally to the source layer **104** including the first and second barrier layer **106A, 106B,** and the first and second gate layers **108A, 108B** that lie on adjacent sides (i.e., left and right) of the source layer **104.** The second portion **116B** is arranged laterally, so that the current flows through it (i.e., the second portion **116B**) in the lateral direction. Moreover, the first portion **116A** may be used in order to control the threshold voltage (Vth) of the member **100.**

In accordance with an embodiment, the first portion **116A** of the member **100** comprises the source layer **104** and a portion of the first gate layer **108A,** and where the second portion **116B** of the member **100** comprises the remainder of the first gate layer **108A** layer and the first barrier layer **106A.** For example, the first portion **116A** of the member **100** includes the portion of the first gate layer **108A** that lies on adjacent side (e.g., left side) of the source layer **104.** And, the second portion **116B** of the member **100** includes the remainder of the first gate layer **108A** and the first barrier layer **106A** that lies on the adjacent side (e.g., left side) of the source layer **104.**

In accordance with an embodiment, the first portion **116A** of the member **100** further comprises a portion of the second gate layer **108B,** and where the second portion **116B** of the member **100** further comprises the remainder of the second gate layer **108B** and the second barrier layer **106B.** For example, the first portion **116A** of the member **100** further includes the portion of the second gate layer **108b** that lies on adjacent side (e.g., right side) of the source layer **104.** And, the second portion **116B** of the member **100** includes the remainder of the second gate layer **108B** and the second barrier layer **106B** that lies on the adjacent side (e.g., right side) of the source layer **104.**

In accordance with an embodiment, the source layer **104** has a first length in a first lateral direction and a length in a second lateral direction, each of the first and second gate layers **108A, 108B** has a first length in a first lateral direction and a length in a second lateral direction, where the lengths of either gate layer are measured from the source layer **104,** and each of the first and second barrier layers **106A, 106B** has a first length in a first lateral direction and a length in a second lateral direction, where the lengths of either barrier layer are measured from the source layer **104,** where the first lateral direction is orthogonal to the second lateral direction. The source layer **104** of the member **100** has the first length (e.g., lateral aperture, Lap) in the first lateral direction and the length in the second lateral direction. The first lateral direction is orthogonal to the second lateral direction. Therefore, it may be stated that the first lateral direction and the second lateral direction corresponds to width (W) and length (L) of the source layer **104.** Similar to the source layer **104,** each of the first gate layer **108A** and the second gate layer **108B** has the first length (e.g., a gate length, L_{G}) in the first lateral direction and the length in the second lateral direction. Similarly, each of the first barrier layer **106A** and the second barrier layer **106B** has the first length (may also be termed as lateral extension of access regions, L_{access}) in the first lateral direction and the length in the second lateral direction. Moreover, the lengths of each of the first and second gate layers **108A, 108B** and each of the first and second barrier layers **106A, 106B** is measured from the source layer **104.**

In accordance with an embodiment, the first length of the source layer **104** in the first lateral direction is in a range of 0.2 µm to 5 µm. The first length (i.e., Lap) of the source layer **104** in the first lateral direction is in a range of 0.2 µm to 5 µm.

In accordance with an embodiment, the length of the source layer **104** in the second lateral direction is in a range of 0.2 µm to 5 µm. The length of the source layer **104** in the second lateral direction may have values in a range of 0.2 µm to 5 µm.

In accordance with an embodiment, the first length of either gate layer in the first lateral direction is in a range of 0.2 µm to 5 µm. In an implementation, the first length (i.e., gate length, L_{G}) of each of the first gate layer **108A** and the second gate layer **108B** in the first lateral direction, that is measured from the source layer **104** in adjacent direction (i.e., left and right direction of the source layer **104**), may be of same value that lies in the range of 0.2 µm up to 5 µm. In another implementation, the first length (i.e., gate length, L_{G}) of each of the first gate layer **108A** and the second gate layer **108B** in the first lateral direction, that is measured from the source layer **104** in adjacent direction (i.e., left and right direction of the source layer **104**), may be of different value that lies in the range of 0.2 µm up to 5 µm. Alternatively stated, each of the first and second gate layers **108A, 108B** may have either same gate lengths or different gate lengths in the first lateral direction.

In accordance with an embodiment, at least one of the gate layers has a second length in the first lateral direction measured from the source layer **104,** where the second length in the first lateral direction is in a range of 0.2 µm to 5 µm. In an implementation, at least one of the first and second gate layers **108A, 108B** has the second length in the first lateral direction in the range of 0.2 µm to 5 µm. Similar to the first length, the second length is also measured from the source layer **104.** Moreover, the first length as well as the second length of each of the first and second gate layers **108A, 108B** in the first lateral direction allows the member **100** to have the first portion **116A** and the second portion **116B.**

In accordance with an embodiment, the length of either gate layer in the second lateral direction is in a range of 0.2 µm to 5 µm. The length of either one of the first and second gate layers **108A, 108B** or both the first and second gate layers **108A, 108B** in the second lateral direction lies in a range of 0.2 µm to 5 µm.

In accordance with an embodiment, the first length of either barrier layer in the first lateral direction is in a range of 1 µm to 20 µm. In an implementation, the first length (i.e., lateral extension of access regions, L_{access}) of each of the first barrier layer **106A** and the second barrier layer **106B** in the first lateral direction, that is measured from the source layer **104** in adjacent direction (i.e., left and right direction of the source layer **104**), may be of same value that lies in a range of 1 µm to 20 µm. In another implementation, the first length (i.e., lateral extension of access regions, L_{access}) of each of the first barrier layer **106A** and the second barrier layer **106B** in the first lateral direction, that is measured from the source layer **104** in adjacent direction (i.e., left and right direction of the source layer **104**), may be of different value that lies in a range of 1 µm to 20 µm. Alternatively stated, each of the first and second barrier layers **106A, 106B** may have either same or different lengths of access regions in the first lateral direction.

In accordance with an embodiment, at least one of the barrier layers has a second length in the first lateral direction measured from the source layer **104,** where the second length in the first lateral direction is in a range of 1 µm to 20 µm. In an implementation, at least one of the first and second barrier layers **106A, 106B** has the second length in the first lateral direction in the range of 1 µm to 20 µm. Similar to the first length, the second length is also measured from the source layer **104.** Moreover, the first length as well as the second length of each of the first and second barrier layers **106A, 106B** in the first lateral direction allows the member **100** to have the first portion **116A** and the second portion **116B.**

In accordance with an embodiment, the length of either barrier layer in the second lateral direction is in a range of 1 µm to 20 µm. The length of either one of the first and second barrier layers **106A, 106B** or both the first and second barrier layers **106A, 106B** in the second lateral direction lies in the range of 1 µm to 20 µm.

In accordance with an embodiment, a concentration of the source layer **104** is in range of 1e16cm⁻³ up to 5e18cm⁻³. In an implementation, Silicon (Si) may be used for n-type doping of gallium nitride (GaN) in the source layer **104** and the concentration of n-type doping lies in the range of 1e16cm⁻³ up to 5e18cm⁻³.

In accordance with an embodiment, a concentration of the gate layers is in a range of 1e18cm⁻³ up to 5e19cm⁻³. Generally, magnesium (Mg) is used for p-type doping of gallium nitride (GaN) in each of the first and second gate layers **108A, 108B** and the concentration of p-type doping lies in the range of 1e18cm⁻³ up to 5e19cm⁻³.

In accordance with an embodiment, a concentration of aluminium in the barrier layers is in a range of 15% to 30%. The concentration of aluminium (Al) in Al-GaN of each of the first and second barrier layers **106A, 106B** lies in the range of 15% to 30%. Moreover, the thickness of each of the first and second barrier layers **106A, 106B** may lie in a range of 10nm to 30nm.

The member **100** enables an independent optimization of the two-dimensional electron gas (2DEG) characteristics and the threshold voltage (Vth) of a semiconductor device (e.g., a power transistor). Moreover, the member **100** manifests a high immunity to dynamic effects (or surface effects). The member **100** is less sensitive to the thickness and concentration (i.e., mole fraction) of each of the first and second barrier layers **106A, 106B.** The member **100** allows a high 2DEG density to boost on-state resistance. However, the on-state resistance and the threshold voltage can be controlled independently. Furthermore, the n-type doping of the source layer **104** affects both the on-state resistance of the semiconductor device as well as its overall breakdown capabilities. Additionally, the member **100** manifests the advantages of a conventional GaN lateral technology as well as the benefits of a vertical device architecture due to the presence of the first portion **116A** and the second portion **116B.**

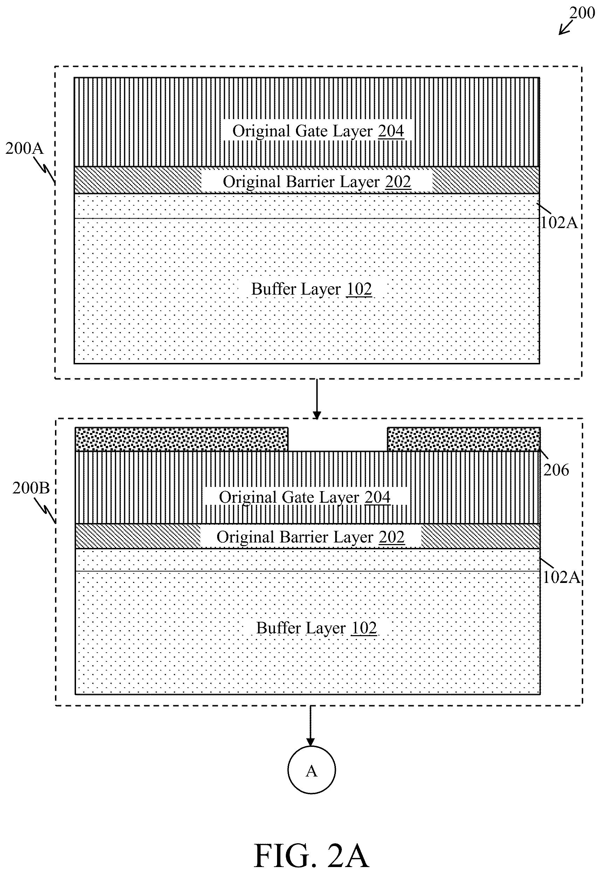

FIGs. 2A, 2B, and 2C collectively illustrate a schematic process for manufacturing a member in two-dimensions (2D), in accordance with an embodiment of the present disclosure. FIGs. 2A, 2B, and 2C are described in conjunction with elements from FIG. 1. With reference to FIGs. 2A, 2B and 2C, there is shown a schematic process **200** for manufacturing the member **100** (of FIG. 1) in two-dimensions (2D). The schematic process **200** includes steps **200A-**to-**200F.** The steps **200A** and **200B** are shown in FIG. 2A. Similarly, the steps **200C** and **200D** are shown in FIG. 2B, and the steps **200E** and **200F** are shown in FIG. 2C.

With reference to FIG. 2A, the schematic process **200** starts with an epitaxial stack. Thereafter, at step **200A,** an original barrier layer **202** is arranged over the buffer layer **102.** The original barrier layer **202** is made of Aluminium Gallium nitride (AlGaN) semiconductor material. The original barrier layer **202** may be arranged either directly on top of the buffer layer **102** or potentially with another material in between the original barrier layer **202** and the buffer layer **102.** For example, the top part **102A** (i.e., UID GaN channel) of the buffer layer **102** may be arranged in between the original barrier layer **202** and the buffer layer **102.** A typical thickness of the top part **102A** (i.e., UID GaN channel) of the buffer layer **102** may lie in a range of 50 nanometers (nm) to 1micrometer (µm).

Thereafter, an original gate layer **204** is arranged over the original barrier layer **202.** The original gate layer **204** is made of p-type doped GaN semiconductor material.

At step **200B,** a sacrificial passivation layer **206** is deposited over the original gate layer **204.** The sacrificial passivation layer **206** may also be referred to as a "hard mask". The sacrificial passivation layer **206** is configured to prevent oxidation of the original gate layer **204** (i.e., p-type doped gallium nitride, pGaN layer). Examples of the sacrificial passivation layer **206** include, but are not limited to, an aluminium oxide layer, aluminium nitride layer, silicon dioxide layer, the silicon nitride layer, and the like. The sacrificial passivation layer **206** is used as a masking layer for subsequent trench etching process. The sacrificial passivation layer **206** may also be referred to as a sacrificial surface passivation layer. The thickness and material composition (i.e., dielectric constant) of the sacrificial passivation layer **206** may be varied to improve the electrical characteristics of a semiconductor device (e.g., a power transistor). After deposition of the sacrificial passivation layer **206** over the original gate layer **204,** a certain portion (e.g., a center portion) of the sacrificial passivation layer **206** is removed.

Now referring to FIG. 2B, at step **200C,** a hole **208** (or a trench) is formed from where, the certain portion of the sacrificial passivation layer **206** is removed. The hole **208** is extended through the original gate layer **204** and the original barrier layer **202.** The hole **208** is formed through subsequent etching of the sacrificial passivation layer **206,** the original gate layer **204** and the original barrier layer **202.** The hole **208** may also be referred to as a trench, or an opening. In an example, the hole **208** may be formed via lithography etching, photolithography, or e-beam lithography. After formation of the hole **208,** the original barrier layer **202** is splitted into the first and second barrier layers **106A, 106B** and the original gate layer **204** is splitted into the first and second gate layers **108A, 108B** (of FIG. 1) lying on adjacent sides (e.g., left and right sides) of the hole **208.**

At step **200D,** the source layer **104** (of FIG. 1) is arranged in the hole **208** along with the sacrificial passivation layer **206** still in place.

In accordance with an embodiment, the hole **208** is formed in the original barrier layer **202** and the original gate layer **204,** the first and second barrier layers **106A, 106B** and the first and second gate layers **108A, 108B,** and where the source layer **104** is a regrown body of n-doped GaN in the hole **208.** The source layer **104** arranged in the hole **208** is made of n-doped GaN semiconductor material. The n-type doping in the source layer **104** improves the on-state resistance as well as threshold voltage of a semiconductor device (e.g., a power transistor) comprising the member **100.**

Now referring to FIG. 2C, at step **200E,** the sacrificial passivation layer **206** is removed. Also, each of the first gate layer **108A** and the second gate layer **108B** is structured through etching. The remaining portion of the first and second gate layers **108A, 108B** define the lateral extension of the gate regions, placed at left and right sides of the source layer **104** (i.e., n-doped GaN regrown region), respectively. Thereafter, a final surface passivation layer **210** is deposited on top surface including top surface of the first and second barrier layers **106A, 106B,** top surface of the first and second gate layers **108A, 108B** and top surface of the source layer **104.**

At step **200F,** various metal contacts and the metal layer **114A** is formed for electric field management. The various metal contacts include the one or more drain (i.e., D) contacts, such as the first drain contact **110A** and the second drain contact **110B,** the one or more gate (i.e., G) contacts, such as the first gate contact **112A** and the second gate contact **112B** and the source contact **114** is formed for electric field management. There is further shown the metal layer **114A,** which is also used for electric field management. The metal layer **114A** allows to lower down the maximum electric field in a specific portion of a semiconductor device (e.g., a power transistor) and hence, improves the overall reliability of the semiconductor device.

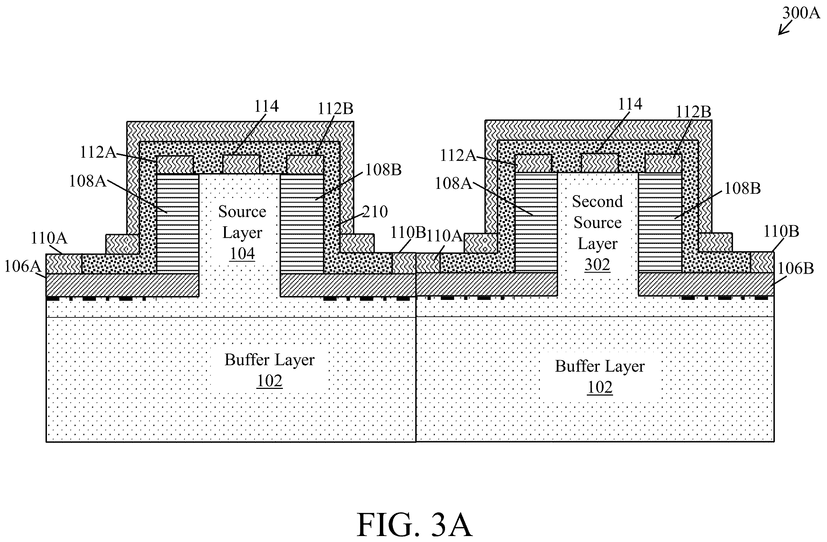

FIG. 3A is a schematic illustration of a member, in accordance with another embodiment of the present disclosure. FIG. 3A is described in conjunction with elements from FIGs. 1, 2A, 2B, and 2C. With reference to FIG. 3A, there is shown a schematic illustration of a member **300A.**

The functioning of the member **300A** is similar to the member **100** (of FIG. 1) except that the member **300A** includes a second source layer **302.**

In accordance with an embodiment, the member **300A** further comprises the second source layer **302.** Similar to the source layer **104,** the second source layer **302** is sandwiched between the first and second barrier layers **106A, 106B** and the first and second gate layers **108A, 108B.**

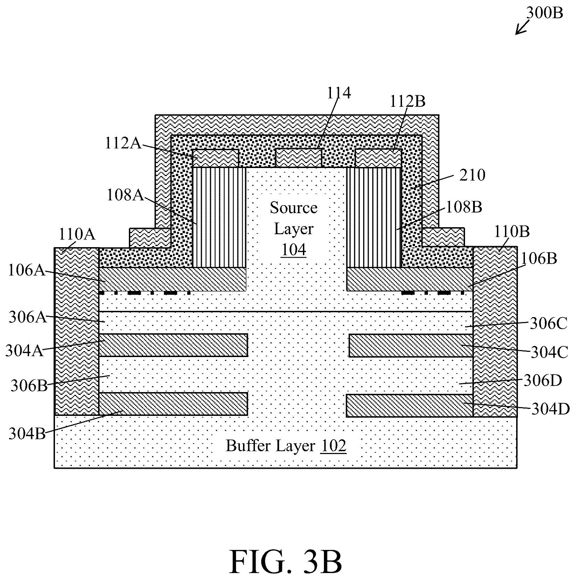

FIG. 3B is a schematic illustration of a member, in accordance with yet another embodiment of the present disclosure. FIG. 3B is described in conjunction with elements from FIGs. 1, 2A, 2B, and 2C. With reference to FIG. 3B, there is shown a schematic illustration of a member **300B** that includes one or more further first barrier layers **304A, 304B** and one or more first intermediate buffer layers **306A, 306B.** The member **300B** further includes one or more further second barrier layers **304C, 304D** and one or more second intermediate buffer layers **306C, 306D.**

In accordance with an embodiment, the member **300B** further comprises one or more further first barrier layers **304A, 304B** and one or more first intermediate buffer layers **306A, 306B** arranged between the first barrier layer **106A** and the buffer layer **102** and one or more further second barrier layers **304C, 304D** and one or more second intermediate buffer layers **306C, 306D** arranged between the second barrier layer **106B** and the buffer layer **102,** where the further barrier layers comprises AlGaN, and where the intermediate buffer layers comprises GaN. In addition to the first barrier layer **106A,** the member **300B** further includes one or more first barrier layers **304, 304B** and the one or more first intermediate buffer layers **306A, 306B.** The one or more further first barrier layers **304, 304B** and the one or more first intermediate buffer layers **306A, 306B** are arranged in between the buffer layer **102** and the first barrier layer **106A** lying on adjacent side (e.g., left side) of the source layer **104.** Additionally, the member **300B** includes the one or more further second barrier layers **304C, 304D** and the one or more second intermediate buffer layers **306C, 306D** arranged between the second barrier layer **106B** and the buffer layer **102.** The one or more further first barrier layers **304, 304B,** the one or more first intermediate buffer layers **306A, 306B,** the one or more further second barrier layers **304C, 304D,** and the one or more second intermediate buffer layers **306C, 306D** enables the member **300B** to have multiple channels in parallel for improved electrical properties. Each of the one or more further first barrier layers **304, 304B,** and the one or more further second barrier layers **304C, 304D** is made of AlGaN semiconductor material. Each of the one or more first intermediate buffer layers **306A, 306B,** and the one or more second intermediate buffer layers **306C, 306D** is made of GaN semiconductor material.

FIGs. 4A and 4B collectively illustrate a schematic process for manufacturing a member in three-dimensions (3D), in accordance with an embodiment of the present disclosure. FIGs. 4A and 4B are described in conjunction with elements from FIGs. 1, 2A, 2B, and 2C. With reference to FIGs. 4A and 4B, there is shown a schematic process **400** for manufacturing the member **100** (of FIG. 1) in three-dimensions (3D). The schematic process **400** includes steps **400A-**to-**400D.** The steps **400A** and **400B** are shown in FIG. 4A. Similarly, the steps **400C** and **400D** are shown in FIG. 4B.

With reference to FIG. 4A, at step **400A,** a trench **402** is formed through etching. The trench **402** is surrounded from all the sides by a barrier layer **404** (i.e., AlGaN layer) and a gate layer **406** (i.e., p-GaN layer). The barrier layer **404** used in three-dimensional structure of the member **100** is nothing but the first and second barrier layers **106A, 106B** as shown in two-dimensional representation of the member **100,** in FIG. 1. Similarly, the gate layer **406** is represented by the first and second gate layers **108A, 108B** in two-dimensional representation of the member **100,** in FIG. 1. At step **400B,** the source layer **104** (of FIG. 1) made of the n-type doped gallium nitride (n-GaN) semiconductor material is arranged (or regrown) in the trench **402.** Alternatively stated, in practice, the source layer **104** is surrounded from all the sides by the barrier layer **404** and the gate layer **406.**

Now, referring to FIG. 4B, at step **400C,** the gate layer **406** (i.e., p-type doped GaN layer) is structured through etching. The source layer **104** has the first length in the first lateral direction and the length in the second lateral direction. The first lateral direction is orthogonal to the second lateral direction. Therefore, it may be stated that the first lateral direction and the second lateral direction corresponds to width (W) and length (L) of the source layer **104.**

In accordance with an embodiment, a height of the source layer **104** is in a range of 0.1µm to 5µm. The source layer **104** (i.e., n-doped GaN regrown region) may be extended above (or below) the gate layer **406.** Therefore, the source layer **104** may have the height (e.g., a vertical trench, Tap) in the range of 0.1µm to 5µm.

In accordance with an embodiment, a height of the gate is in a range of 0.1µm to 5µm. The gate layer **406** has the height in the range of 0.1µm to 5µm.

At step **400D,** various metal contacts are formed for electric field management. The various metal contacts include one or more drain (i.e., D) contacts **408A, 408B** formed over the barrier layer **404,** one or more gate (i.e., G) contacts, such as a gate contact **410** formed over the gate layer **406** and a source contact **412** formed over the source layer **104.** Each of the various metal contacts, that is the one or more drain (i.e., D) contacts **408A, 408B,** the gate contact **410** and the source contact **412** surrounds the source layer **104** from all sides. The one or more drain (i.e., D) contacts **408A, 408B** used in three-dimensional structure of the member **100** is nothing but the first and second drain contacts **110A, 110B** as shown in two-dimensional representation of the member **100,** in FIG. 1. Similarly, the gate contact **410,** and the source contact **412** is represented by one of the first and second gate contacts **112A, 112B,** and the source contact **114,** respectively, as shown in two-dimensional representation of the member **100,** in FIG. 1.

The schematic process **400** for manufacturing the member **100** (of FIG. 1) in three-dimensions (3D) allows to produce a series of the member **100** (or GaN fins) that can be connected in parallel by sharing the same source, drain and gate contacts. The schematic process **400** allows the member **100** to have an additional degree of freedom in tailoring the threshold voltage as well as electrical characteristics of a semiconductor device (e.g., a power transistor).

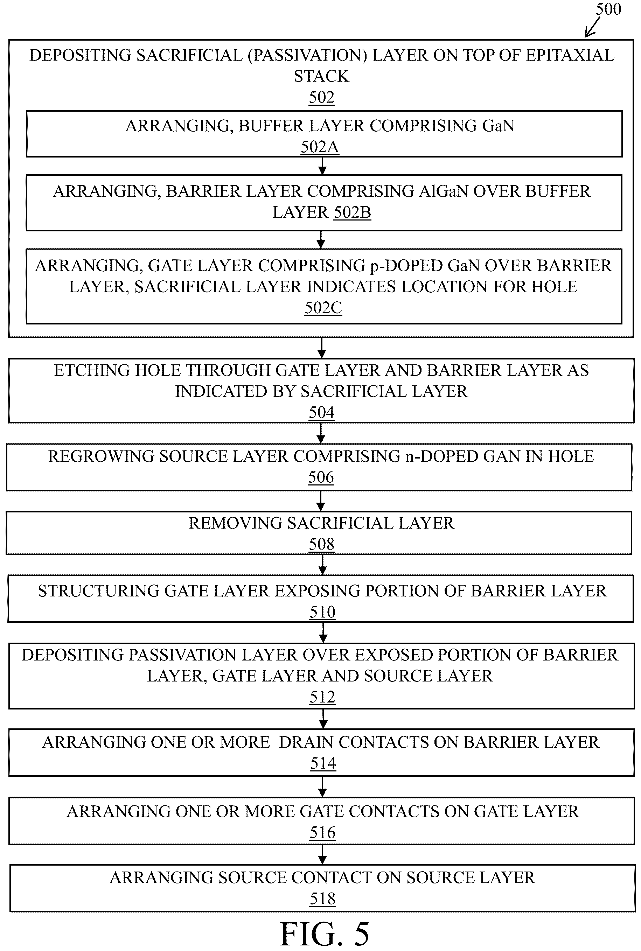

FIG. 5 illustrates a method of manufacturing a member, in accordance with an embodiment of the present disclosure. FIG. 5 is described in conjunction with elements from FIGs. 1, 2A, 2B, 2C, 4A, and 4B. With reference to FIG. 5, there is shown a method **500** for manufacturing the member **100** (of FIG. 1). The method **500** includes steps **502-**to-**518.** The step **502** includes **502A, 502B** and **502C** sub-steps. The method **500** is executed by the member **100.**

The present disclosure provides the method **500** of manufacturing the member **100** in two-dimensions as well as in three-dimensions.

At step **502,** the method **500** comprises depositing a sacrificial (passivation) layer on top of an epitaxial stack. The sacrificial layer (i.e., the sacrificial passivation layer **206**) may be configured to prevent oxidation of top surface of the epitaxial stack.

At sub-step **502A,** the epitaxial stack comprises arranging the buffer layer **102** comprising GaN. The epitaxial stack starts with arranging the buffer layer **102** that is made of gallium nitride (GaN) semiconductor material.

At sub-step **502B,** the epitaxial stack further comprises arranging a barrier layer comprising Al-GaN arranged over the buffer layer **102.** In the epitaxial stack, the barrier layer (i.e., the original barrier layer **202,** of FIG. 2A) is arranged over the buffer layer **102.** The barrier layer (i.e., the original barrier layer **202**) is made of aluminium gallium nitride (Al-GaN) semiconductor material.

At sub-step **502C,** the epitaxial stack further comprises arranging a gate layer comprising p-doped GaN arranged over the barrier layer, where the sacrificial layer indicates location for a hole **208** (or trench). Furthermore, in the epitaxial stack, the gate layer (i.e., the original gate layer **204,** of FIG. 2A) is arranged over the barrier layer (i.e., the original barrier layer **202**). The gate layer (i.e., the original gate layer **204**) is made of p-type doped gallium nitride (p-GaN) semiconductor material. Thereafter, the hole **208** (or the trench) is made by removing a certain portion of the sacrificial layer (i.e., the sacrificial passivation layer **206**).

At step **504,** the method **500** further comprises etching the hole **208** through the gate layer and the barrier layer as indicated by the sacrificial layer. The hole **208** is formed through subsequent etching of the sacrificial layer (i.e., the sacrificial passivation layer **206**), the gate layer (i.e., the original gate layer **204**) and the barrier layer (i.e., the original barrier layer **202**).

At step **506,** the method **500** further comprises regrowing the source layer **104** comprising n-doped GaN in the hole **208.** Thereafter, the source layer **104** is regrown in the hole **208.** The source layer **104** is made of n-doped gallium nitride (n-GaN) semiconductor material.

At step **508,** the method **500** further comprises removing the sacrificial layer. After regrowing the source layer **104,** the sacrificial layer (i.e., the sacrificial passivation layer **206**) is removed.

At step **510,** the method **500** further comprises structuring the gate layer exposing a portion of the barrier layer. Each of the gate layers (i.e., the first and second gate layers **108A, 108B**) is structured by exposing the portion of each of the barrier layers (i.e., the first and second barrier layers **106A, 106B**).

At step **512,** the method **500** further comprises depositing a passivation layer over the exposed portion of the barrier layer, the gate layer and the source layer **104.** Thereafter, the passivation layer (i.e., the final surface passivation layer **210,** of FIG. 2C) is deposited over the exposed portion of each of the first and second barrier layers **106A, 106B,** the first and second gate layers **108A, 108B** and the source layer **104.**

At step **514,** the method **500** further comprises arranging one or more drain contacts **110A, 110B** on the barrier layer. The one or more drain (i.e., D) contacts, such as the first drain contact **110A** and the second drain contact **110B** are arranged on the first and second barrier layers **106A, 106B,** respectively, for electric field management.

At step **516,** the method **500** further comprises arranging one or more gate contacts **112A, 112B** on the gate layer. The one or more gate (i.e., G) contacts, such as the first gate contact **112A** and the second gate contact **112B** are arranged on the first and second gate layers **108A, 108B,** respectively, for electric field management.

At step **518,** the method **500** further comprises arranging the source contact **114** on the source layer **104.** The source contact **114** is arranged on the source layer **104,** respectively, for electric field management.

In accordance with an embodiment, the member may be any one of the members **100** (of FIG. 1) or **300A** (of FIG. 3A), or **300B** (of FIG. 3B), that may have either two-dimensional (2D) or three-dimensional (3D) structure.

Thus, the method **500** enables the manufacturing of the member **100** that provides an independent optimization of the two-dimensional electron gas (2DEG) characteristics and the threshold voltage (Vth) of a semiconductor device (e.g., a power transistor). Moreover, the member **100** manifests a high immunity to dynamic effects (or surface effects). Furthermore, the n-type doping of the source layer **104** affects both the on-state resistance of the semiconductor device as well as its overall breakdown capabilities. Additionally, the member **100** manifests the advantages of a conventional GaN lateral technology as well as the benefits of a vertical device architecture due to the presence of the first portion **116A** and the second portion **116B.**

The steps **502**-to-**518** are only illustrative and other alternatives can also be provided where one or more steps are added, one or more steps are removed, or one or more steps are provided in a different sequence without departing from the scope of the claims herein.

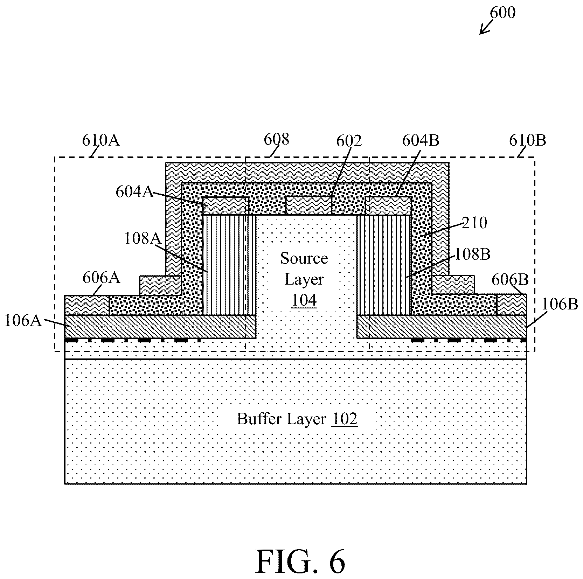

FIG. 6 is a schematic illustration of a field effect transistor (FET), in accordance with an embodiment of the present disclosure. FIG. 6 is described in conjunction with elements from FIGs. 1, 2A, 2B, 2C, 4A, and 4B. With reference to FIG. 6, there is shown a field effect transistor (FET) **600** that includes a source contact **602,** one or more gate contacts, such as a first gate contact **604A** and a second gate contact **604B,** and one or more drain contacts, such as a first drain contact **606A** and a second drain contact **606B.** The FET **600** further includes a junction field effect transistor (JFET) **608** and a first and second heterostructure FETs **610A, 610B.**

The FET **600** is a gallium nitride (GaN) semiconductor device (e.g., power transistor) which comprises the advantage of a conventional GaN lateral technology and the benefits of a vertical GaN semiconductor architecture (e.g., the member **100**). In an implementation, the FET **600** may be a metal oxide semiconductor (MOS) FET.

The JFET **608** is arranged to provide the source contact (S) **602** of the FET **600** and where the first and second heterostructure FETs **610A, 610B** are arranged to provide the one or more gate contacts **604A, 604B** and the one or more drain contacts **606A, 606B** of the FET **600.** The first and second heterostructure FETs **610A, 610B** may also be referred to as p-GaN high electron mobility transistors (HEMT).

In accordance with an embodiment, the first and second heterostructure FETs **610A, 610B** are arranged to provide each a gate and a drain of the one or more gate contacts **604A, 604B** and the one or more drain contacts **606A, 606B** of the FET **600.** For example, the first heterostructure FET **610A** is arranged to provide the first gate contact **604A** and the first drain contact **606A** on adjacent side (e.g., left side) of the JFET **608.** Similarly, the second heterostructure FET **610B** is arranged to provide the second gate contact **604B** and the second drain contact **606B** on adjacent side (e.g., right side) of the JFET **608.**

In accordance with an embodiment, the first and second heterostructure FETs **610A, 610B** are p-GaN heterostructure FETs.

In accordance with an embodiment, the first and second heterostructure FETs **610A, 610B** are formed as one structure enveloping the JFET **608.** Alternatively stated, the JFET **608** is sandwiched between the first and second heterostructure FETs **610A, 610B.**

In accordance with an embodiment, the FET **600** provides for a threshold voltage in the range of 2 to 6 V. The FET **600** provides the threshold voltage in the range of approximately 2V to more than 6V.

In accordance with an embodiment, the FET **600** comprises the member **100, 300A, 300B.** The FET **600** may comprise any one of the members **100, 300A, 300B.**

The FET **600** is a semi-vertical semiconductor device due to the presence of the JFET **608** and the first and second heterostructure FETs **610A, 610B.** Since the FET **600** is the semi-vertical semiconductor device, a very high integration density can be obtained. The FET **600** allows a tunable threshold voltage, which can be controlled using different parameters, such as by controlling the doping and dimensions (e.g., length and depth) of the JFET **608** and by controlling the doping and dimensions of each of the first and second barrier layers **106A, 106B.** Due to the presence of two channels in parallel, the FET **600** drives a much higher current than a conventional pGaN semiconductor device. Moreover, the FET **600** manifests a high immunity to dynamic effects (or surface effects). Additionally, the FET **600** manifests an independent optimization of the two-dimensional electron gas (2DEG) characteristics and the threshold voltage.

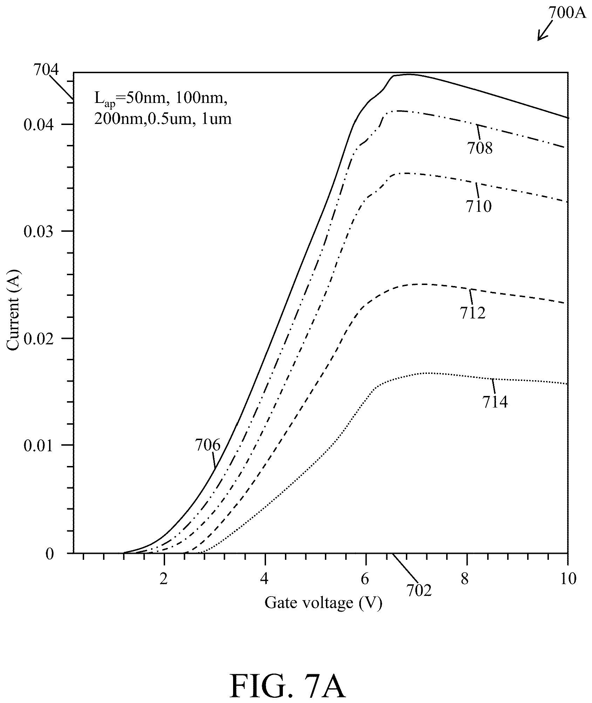

FIG. 7A is a graphical representation that illustrates simulated electrical transfer characteristics of a semiconductor device, as a function of voltage applied to a gate electrode and for different values of lateral extension of gallium nitride (GaN) regrown region, in accordance with an embodiment of the present disclosure. FIG. 7A is described in conjunction with elements from FIGs. 1, 2A, 2B, 2C, 3A, 3B, 4A, 4B, and 6. With reference to FIG. 7A, there is shown a graphical representation **700A** that includes a X-axis **702** that illustrates gate voltage and a Y-axis **704** that illustrates current in amperes (A).

With reference to the graphical representation **700A,** a first line **706,** a second line **708,** a third line **710,** a fourth line **712** and a fifth line **714,** collectively illustrate the simulated electrical transfer characteristics of a semiconductor device (e.g., the FET **600**), as a function of voltage applied to a gate electrode and for different values of lateral extension of gallium nitride (GaN) regrown region (i.e., the source layer **104**). The different values of lateral extension of gallium nitride (GaN) regrown region (i.e., the source layer **104**) may be of 50nm, 100nm, 200nm,0.5µm, and 1µm. The additional device parameter (i.e., source layer **104**) allows a fine tuning of the semiconductor device's (i.e., the FET **600**) threshold voltage as well as of the saturation current.

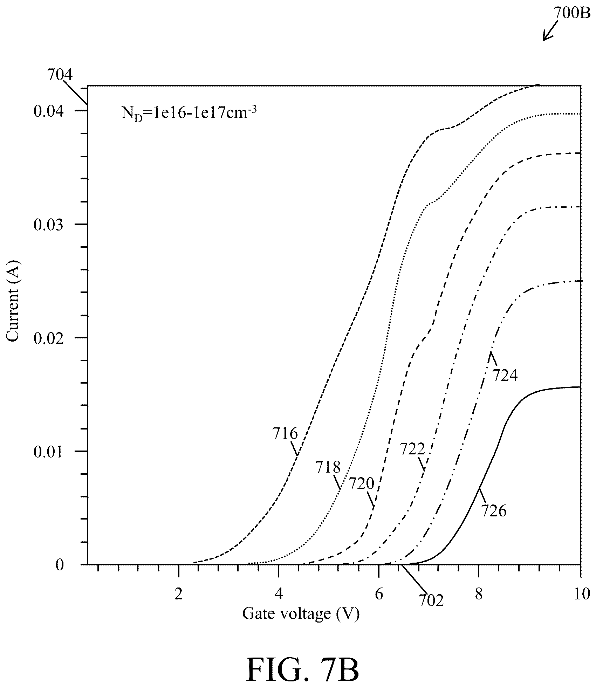

FIG. 7B is a graphical representation that illustrates simulated electrical transfer characteristics of a semiconductor device, as a function of voltage applied to a gate electrode and for different values of n-type doping concentration in the gallium nitride (GaN) regrown region, in accordance with an embodiment of the present disclosure. FIG. 7B is described in conjunction with elements from FIGs. 1, 2A, 2B, 2C, 3A, 3B, 4A, 4B, 6, and 7A. With reference to FIG. 7B, there is shown a graphical representation **700B** that includes the X-axis **702** that illustrates gate voltage and the Y-axis **704** that illustrates current in amperes (A).

With reference to the graphical representation **700B,** a first line **716,** a second line **718,** a third line **720,** a fourth line **722,** a fifth line **724,** and a sixth line **726,** collectively, illustrate the simulated electrical transfer characteristics of a semiconductor device (e.g., the FET **600**), as a function of voltage applied to a gate electrode and for different values of the n-type doping concentration in the gallium nitride (GaN) regrown region (i.e., the source layer **104**). As shown in the FIG. 7B, the semiconductor device (e.g., the FET **600**) manifests a tunable threshold voltage approximately from 2 volts (V) to more than 6V. When the semiconductor device (e.g., the FET **600**) is compared with a conventional p-GaN power MOSFETs that has a typical threshold voltage between 1V to 1.5V, it is evident that the semiconductor device (e.g., the FET **600**) manifests an improved threshold voltage, that has a positive impact on the gate driver design and an overall system level performance.

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural. The word "exemplary" is used herein to mean "serving as an example, instance or illustration". Any embodiment described as "exemplary" is not necessarily to be construed as preferred or advantageous over other embodiments or to exclude the incorporation of features from other embodiments. The word "optionally" is used herein to mean "is provided in some embodiments and not provided in other embodiments". It is appreciated that certain features of the present disclosure, which are, for clarity, described in the context of separate embodiments, may also be provided in combination in a single embodiment. Conversely, various features of the invention, which are, for brevity, described in the context of a single embodiment, may also be provided separately or in any suitable combination or as suitable in any other described embodiment of the disclosure.

Further embodiments of the present invention are provided in the following. It should be noted that the numbering used in the following section does not necessarily need to comply with the numbering used in the previous sections.

**Embodiment 1.** A member (100, 300A, 300B) comprising a buffer layer (102) comprising GaN, the member (100, 300A, 300B) being characterized in that the member (100, 300A, 300B) further comprises:
a source layer (104) arranged on top of the buffer layer (102), the source layer (104) comprising n-doped GaN;
a first barrier layer (106A) comprising Al-GaN arranged over the buffer layer (102) and a first gate layer (108A) comprising p-doped GaN arranged over the first barrier layer (106A), wherein the first barrier layer (106A) and the first gate layer (108A) is arranged adjacent the source layer (104) on one side; and
a second barrier layer (106B) comprising Al-GaN arranged over the buffer layer (102) and a second gate layer (108B) comprising p-doped GaN arranged over the second barrier layer (106B), wherein the second barrier layer (106B) and the second gate layer (108B) is arranged adjacent the source layer (104) on another side.

**Embodiment 2.** The member (100, 300A, 300B) according to embodiment 1, wherein one or more drain, D, contacts (110A, 110B) are arranged on at least one of the first and second barrier layers (106A, 106B), one or more gate, G, contacts (112A, 112B) are arranged on at least one of the first and second gate layers (108A, 108B), and a source, S, contact (114) is arranged on the source layer (104).

**Embodiment 3.** The member (100, 300A, 300B) according to embodiments 1 or 2, wherein the source layer (104) is arranged in a hole (208) in the first and second barrier layers (106A, 106B) and the first and second gate layers (108A, 108B), wherein the source layer (104) is sandwiched between the first and second barrier layers (106A, 106B) and the first and second gate layers (108A, 108B).

**Embodiment 4.** The member (100, 300A, 300B) according to embodiment 3, wherein the hole (208) is formed in an original barrier layer (202) and an original gate layer (204), the first and second barrier layers (106A, 106B) and the first and second gate layers (108A, 108B), and wherein the source layer (104) is a regrown body of n-doped GaN in the hole (208).

**Embodiment 5.** The member (100, 300A, 300B) according to any one of embodiments 1 to 4, wherein the member (100, 300A, 300B) comprises
a first portion (116A) of the member (100, 300A, 300B), the first portion (116A) being arranged, in operation, to have current flow through it in a vertical direction, and
a second portion (116B) of the member (100, 300A, 300B), the second portion (116B) being arranged, in operation, to have current flow through it in a lateral direction, and wherein the threshold voltage of the member (100, 300A, 300B) is dependent on the first portion (116A).

**Embodiment 6.** The member (100, 300A, 300B) according to embodiment 5, wherein the first portion (116A) of the member (100, 300A, 300B) comprises the source layer (104) and a portion of the first gate layer (108A), and wherein the second portion (116B) of the member (100, 300A, 300B) comprises the remainder of the first gate layer (108A), and the first barrier layer (106A).

**Embodiment 7.** The member (100, 300A, 300B) according to embodiment 6, wherein the first portion (116A) of the member (100, 300A, 300B) further comprises a portion of the second gate layer (108B), and wherein the second portion (116B) of the member (100, 300A, 300B) further comprises the remainder of the second gate layer (108B), and the second barrier layer (106B).

**Embodiment 8.** The member (100, 300A, 300B) according to any one of embodiments 1 to 7, wherein
the source layer (104) has a first length in a first lateral direction and a length in a second lateral direction,
each of the first and second gate layers (108A, 108B) has a first length in a first lateral direction and a length in a second lateral direction, wherein the lengths of either gate layer are measured from the source layer (104), and
each of the first and second barrier layers (106A, 106B) has a first length in a first lateral direction and a length in a second lateral direction, wherein the lengths of either barrier layer are measured from the source layer (104), wherein
the first lateral direction is orthogonal to the second lateral direction.

**Embodiment 9.** The member (100, 300A, 300B) according to embodiment 8, wherein the first length of the source layer (104) in the first lateral direction is in a range of 0.2 µm to 5 µm.

**Embodiment 10.** The member (100, 300A, 300B) according to embodiments 8 or 9, wherein the length of the source layer (104) in the second lateral direction is in a range of 0.2 µm to 5 µm.

**Embodiment 11.**The member (100, 300A, 300B) according to any one of embodiments 8 to 10, wherein the first length of either gate layer in the first lateral direction is in a range of 0.2 µm to 5 µm.

**Embodiment 12.** The member (100, 300A, 300B) according to embodiment 11, wherein at least one of the gate layers has a second length in the first lateral direction measured from the source layer (104), wherein the second length in the first lateral direction is in a range of 0.2 µm to 5 µm.

**Embodiment 13.** The member (100, 300A, 300B) according to any one of embodiments 8 to 12, wherein the length of either gate layer in the second lateral direction is in a range of 0.2 µm to 5 µm.

**Embodiment 14.** The member (100, 300A, 300B) according to any one of embodiments 8 to 13, wherein the first length of either barrier layer in the first lateral direction is in a range of 1 µm to 20 µm.

**Embodiment 15.** The member (100, 300A, 300B) according to embodiment 14, wherein at least one of the barrier layers has a second length in the first lateral direction measured from the source layer (104), wherein the second length in the first lateral direction is in a range of 1 µm to 20 µm.

**Embodiment 16.** The member (100, 300A, 300B) according to any one of embodiments 8 to 15, wherein the length of either barrier layer in the second lateral direction is in a range of 1 µm to 20 µm.

**Embodiment 17.** The member (100, 300A, 300B) according to any one of embodiments 8 to 16, wherein a height of the source layer (104) is in a range of 0.1µm to 5µm.

**Embodiment 18.** The member (100, 300A, 300B) according to any one of embodiments 8 to 17, wherein a height of either gate layer is in a range of 0.1µm to 5µm.

**Embodiment 19.** The member (100, 300A, 300B) according to any one of embodiments 8 to 18, wherein a concentration of the source layer (104) is in range of 1e16cm-3 up to 5e18cm-3.

**Embodiment 20.** The member (100, 300A, 300B) according to any one of embodiments 8 to 19, wherein a concentration of either gate layer is in a range of 1e18cm-3 up to 5e19cm-3.

**Embodiment 21.** The member (100, 300A, 300B) according to any one of embodiments 8 to 20, wherein a concentration of aluminium in either barrier layer is in a range of 15% to 30%.

**Embodiment 22.** The member (100, 300A, 300B) according to any one of embodiments 1 to 21, wherein the member (100, 300A, 300B) further comprises a second source layer (302).

**Embodiment 23.** The member (100, 300A, 300B) according to any one of embodiments 1 to 22, wherein the member (100, 300A, 300B) further comprises one or more further first barrier layers (304A, 304B) and one or more first intermediate buffer layers (306A, 306B) arranged between the first barrier layer (106A) and the buffer layer (102) and one or more further second barrier layers (304C, 304D) and one or more second intermediate buffer layers (306C, 306D) arranged between the second barrier layer (106B) and the buffer layer (102), wherein the further barrier layers comprises AlGaN, and wherein the intermediate buffer layers comprises GaN.

**Embodiment 24.** A method (500) of manufacturing a member (100, 300A, 300B), the method (500) comprising:
depositing a sacrificial layer on top of an epitaxial stack, the epitaxial stack comprising:
a buffer layer (102) comprising GaN,
a barrier layer comprising Al-GaN arranged over the buffer layer (102), and
a gate layer comprising p-doped GaN arranged over the barrier layer, wherein the sacrificial layer indicates location for a hole (208);
etching the hole (208) through the gate layer and the barrier layer as indicated by the sacrificial layer;
regrowing a source layer (104) comprising n-doped GaN in the hole (208);
removing the sacrificial layer;
structuring the gate layer exposing a portion of the barrier layer;
depositing a passivation layer over the exposed portion of the barrier layer, the gate layer and the source layer (104);
arranging one or more drain contacts (110A, 110B) on the barrier layer;
arranging one or more gate contacts (112A, 112B) on the gate layer; and
arranging a source contact (114) on the source layer (104).

**Embodiment 25.** The method (500) according to embodiment 24, wherein the member (100, 300A, 300B) is the member (100, 300A, 300B) according to any one of embodiments 1 to 23.

**Embodiment 26.** A FET (600) having a source contact (602), one or more gate contacts (604A, 604B) and one or more drain contacts (606A, 606B), the FET (600) comprising a JFET (608) and a first and a second heterostructure FETs (610A, 610B), wherein the JFET (608) is arranged to provide the source contact (S) (602) of the FET (600) and, wherein the first and the second heterostructure FETs (610A, 610B) are arranged to provide the one or more gate contacts (604A, 604B) and the one or more drain contacts (606A, 606B) of the FET (600).

**Embodiment 27.** The FET (600) according to embodiment 26, wherein the first and the second heterostructure FETs (610A, 610B) are arranged to provide each a gate and a drain of the one or more gate contacts (604A, 604B) and the one or more drain contacts (606A, 606B) of the FET (600).

**Embodiment 28.** The FET (600) according to embodiments 26 or 27, wherein the first and the second heterostructure FETs (610A, 610B) are pGaN heterostructure FETs.

**Embodiment 29.** The FET (600) according to any one of embodiments 26 to 28, wherein the first and the second heterostructure FETs (610A, 610B) are formed as one structure enveloping the JFET (608).

**Embodiment 30.** The FET (600) according to any one of embodiments 26 to 29, wherein the FET (600) provides for a threshold voltage in the range of 2 to 6 V.

**Embodiment 31.** The FET (600) according to any one of embodiments 26 to 30, wherein the FET (600) comprises a member (100, 300A, 300B) according to any one of embodiments 1 to 23.

## Claims

1. A member (100, 300A, 300B) comprising a buffer layer (102) comprising GaN, the member (100, 300A, 300B) being **characterized in that** the member (100, 300A, 300B) further comprises:
a source layer (104) arranged on top of the buffer layer (102), the source layer (104) comprising n-doped GaN;
a first barrier layer (106A) comprising Al-GaN arranged over the buffer layer (102) and a first gate layer (108A) comprising p-doped GaN arranged over the first barrier layer (106A), wherein the first barrier layer (106A) and the first gate layer (108A) is arranged adjacent the source layer (104) on one side; and
a second barrier layer (106B) comprising Al-GaN arranged over the buffer layer (102) and a second gate layer (108B) comprising p-doped GaN arranged over the second barrier layer (106B), wherein the second barrier layer (106B) and the second gate layer (108B) is arranged adjacent the source layer (104) on another side; wherein
one or more drain, D, contacts (110A, 110B) are arranged on at least one of the first and second barrier layers (106A, 106B),
one or more gate, G, contacts (112A, 112B) are arranged on at least one of the first and second gate layers (108A, 108B), and
a source, S, contact (114) is arranged on the source layer (104).

2. The member (100, 300A, 300B) according to claim 1, wherein the source layer (104) is arranged in a hole (208) in the first and second barrier layers (106A, 106B) and the first and second gate layers (108A, 108B), wherein the source layer (104) is sandwiched between the first and second barrier layers (106A, 106B) and the first and second gate layers (108A, 108B).

3. The member (100, 300A, 300B) according to claim 2, wherein the hole (208) is formed in an original barrier layer (202) and an original gate layer (204), the first and second barrier layers (106A, 106B) and the first and second gate layers (108A, 108B), and wherein the source layer (104) is a regrown body of n-doped GaN in the hole (208).

4. The member (100, 300A, 300B) according to any preceding claim, wherein the member (100, 300A, 300B) comprises
a first portion (116A) of the member (100, 300A, 300B), the first portion (116A) being arranged, in operation, to have current flow through it in a vertical direction, and
a second portion (116B) of the member (100, 300A, 300B), the second portion (116B) being arranged, in operation, to have current flow through it in a lateral direction, and wherein the threshold voltage of the member (100, 300A, 300B) is dependent on the first portion (116A);
wherein the first portion (116A) of the member (100, 300A, 300B) comprises the source layer (104) and a portion of the first gate layer (108A), and wherein the second portion (116B) of the member (100, 300A, 300B) comprises the remainder of the first gate layer (108A), and the first barrier layer (106A).

5. The member (100, 300A, 300B) according to claim 4, wherein the first portion (116A) of the member (100, 300A, 300B) further comprises a portion of the second gate layer (108B), and wherein the second portion (116B) of the member (100, 300A, 300B) further comprises the remainder of the second gate layer (108B), and the second barrier layer (106B).

6. The member (100, 300A, 300B) according to any preceding claim, wherein
the source layer (104) has a first length in a first lateral direction and a length in a second lateral direction,
each of the first and second gate layers (108A, 108B) has a first length in a first lateral direction and a length in a second lateral direction, wherein the lengths of either gate layer are measured from the source layer (104), and
each of the first and second barrier layers (106A, 106B) has a first length in a first lateral direction and a length in a second lateral direction, wherein the lengths of either barrier layer are measured from the source layer (104), wherein
the first lateral direction is orthogonal to the second lateral direction.

7. The member (100, 300A, 300B) according to claim 6, wherein the first length of the source layer (104) in the first lateral direction is in a range of 0.2 µm to 5 µm and/or wherein the length of the source layer (104) in the second lateral direction is in a range of 0.2 µm to 5 µm; and/or wherein the first length of either gate layer in the first lateral direction is in a range of 0.2 µm to 5 µm and wherein at least one of the gate layers has a second length in the first lateral direction measured from the source layer (104), wherein the second length in the first lateral direction is in a range of 0.2 µm to 5 µm.

8. The member (100, 300A, 300B) according to any of claims 6 to 7, wherein the length of either gate layer in the second lateral direction is in a range of 0.2 µm to 5 µm; and/or wherein the first length of either barrier layer in the first lateral direction is in a range of 1 µm to 20 µm; and wherein at least one of the barrier layers has a second length in the first lateral direction measured from the source layer (104), wherein the second length in the first lateral direction is in a range of 1 µm to 20 µm.

9. The member (100, 300A, 300B) according to any of claims 6 to 8, wherein the length of either barrier layer in the second lateral direction is in a range of 1 µm to 20 µm; and/or wherein a height of the source layer (104) is in a range of 0.1µm to 5µm; and/or wherein a height of either gate layer is in a range of 0.1µm to 5µm.

10. The member (100, 300A, 300B) according to any of claims 6 to 9, wherein a concentration of the source layer (104) is in range of 1e16cm⁻³ up to 5e18cm⁻³; and/or wherein a concentration of either gate layer is in a range of 1e18cm⁻³ up to 5e19cm⁻³; and/or wherein a concentration of aluminum in either barrier layer is in a range of 15% to 30%.

11. The member (100, 300A, 300B) according to any preceding claim, wherein the member (100, 300A, 300B) further comprises a second source layer (302).

12. The member (100, 300A, 300B) according to any preceding claim, wherein the member (100, 300A, 300B) further comprises one or more further first barrier layers (304A, 304B) and one or more first intermediate buffer layers (306A, 306B) arranged between the first barrier layer (106A) and the buffer layer (102) and one or more further second barrier layers (304C, 304D) and one or more second intermediate buffer layers (306C, 306D) arranged between the second barrier layer (106B) and the buffer layer (102), wherein the further barrier layers comprises AlGaN, and wherein the intermediate buffer layers comprises GaN.

13. A FET (600) having a source contact (602), one or more gate contacts (604A, 604B) and one or more drain contacts (606A, 606B), the FET (600) comprising a JFET (608) and a first and a second heterostructure FETs (610A, 610B), wherein the JFET (608) is arranged to provide the source contact (S) (602) of the FET (600) and, wherein the first and the second heterostructure FETs (610A, 610B) are arranged to provide the one or more gate contacts (604A, 604B) and the one or more drain contacts (606A, 606B) of the FET (600).

14. The FET (600) according to claim 13, wherein the first and the second heterostructure FETs (610A, 610B) are arranged to provide each a gate and a drain of the one or more gate contacts (604A, 604B) and the one or more drain contacts (606A, 606B) of the FET (600).

15. The FET (600) according to claim 13 or 14, wherein the first and the second heterostructure FETs (610A, 610B) are pGaN heterostructure FETs; and/or wherein the first and the second heterostructure FETs
